# EUROPÄISCHE PATENTSCHRIFT

(11) **EP 1 141 835 B1**
(45) Veröffentlichungstag und Bekanntmachung des Hinweises auf die Patenterteilung: **31.07.2002**
(21) Anmeldenummer: 99966834.6
(22) Anmeldetag: 07.12.1999
(51) Int. Cl.: G06F 11/20

(54) **INTEGRIERTER SPEICHER MIT REDUNDANZ**
INTEGRATED MEMORY WITH REDUNDANCY
MEMOIRE INTEGREE AVEC REDONDANCE

(30) Priorität: 22.12.1998 DE 19859517
(43) Veröffentlichungstag der Anmeldung: 10.10.2001
(73) Patentinhaber: Infineon Technologies AG, 81669 München (DE)
(72) Erfinder: NEUHOLD, Ernst, A-8052 Graz (AT); HÖNIGSCHMID, Heinz, D-82343 Pöcking (DE); BRAUN, Georg, D-80339 München (DE); MANYOKI, Zoltan, D-81739 München (DE); BÖHM, Thomas, D-85604 Zorneding (DE); RÖHR, Thomas, D-85609 Aschheim (DE)
(74) Vertreter: Epping Hermann & Fischer
(86) Internationale Anmeldenummer: DE9903905
(87) Internationale Veröffentlichungsnummer: WO0038066

(56) Entgegenhaltungen:
- US-A- 5 761 138
- PATENT ABSTRACTS OF JAPAN vol. 1996, no. 02, 29. Februar 1996 (1996-02-29) & JP 07 272499 A (MITSUBISHI ELECTRIC CORP), 20. Oktober 1995 (1995-10-20)
- PATENT ABSTRACTS OF JAPAN vol. 013, no. 279 (P-891), 27. Juni 1989 (1989-06-27) & JP 01 066762 A (MITSUBISHI ELECTRIC CORP), 13. März 1989 (1989-03-13)

## Beschreibung

Die Erfindung betrifft einen integrierten Speicher mit Redundanz.

Es ist allgemein bekannt, defekte Speicherzellen eines Speichers durch redundante Speicherzellen zu ersetzen und auf diese Weise den Speicher zu reparieren. Die redundanten Speicherzellen sind dabei entweder entlang redundanter Wortleitungen oder redundanter Bitleitungen angeordnet. In der US 5,568,432 A ist beispielsweise ein integrierter Speicher mit einer redundanten Bitleitung beschrieben, die zum Ersetzen einer der normalen Bitleitungen, entlang derer die normalen Speicherzellen angeordnet sind, vorgesehen ist. Die normale Bitleitung ist einem Leseverstärker zugeordnet, der beim Auslesen der Speicherzellen die in ihnen gespeicherte Information verstärkt nach außerhalb des Speichers liefert. Der redundanten Bitleitung ist ein redundanter Leseverstärker zugeordnet, der im Redundanzfall, das heißt nach Durchführung des Ersetzens der normalen Bitleitung durch die redundante Bitleitung, zum Verstärken von aus den redundanten Speicherzellen ausgelesenen Informationen dient. Im Redundanzfall wird die einen Defekt aufweisende normale Bitleitung mit ihrem normalen Leseverstärker durch die redundante Bitleitung mit ihrem redundanten Leseverstärker ersetzt.

In der US-A-5 761 138 ist ein Halbleiterspeicher mit flexibler Redundanzblockarchitektur beschrieben. Blöcke mit redundanten Leseverstärkern enthalten jeweils vier Leseverstärker, die ausgangsseitig mit je einer Datenleitung verbunden sind und eingangsseitig gemeinsam an eine redundante globale Datenein-/Datenausgabeleitung angeschlossen sind. Je vier solcher redundanter globale Datenein-/Datenausgabeleitung bilden einen Bus. Daran sind wiederum redundante Leseverstärker angeschlossen, die mit redundanten Speicherzellenfeldern verbunden sind. Die Redundanzstruktur dient zum Ersatz von Leseverstärkern in Speicherzellenfeldern, die aufgeteilte Wortleitungen und Bitleitungen umfassen.

Der Erfindung liegt die Aufgabe zugrunde, einen integrierten Speicher anzugeben, bei dem über mehrere normale Leseverstärker gleichzeitig Daten ausgelesen werden können, bei dem jedem Leseverstärker mehrere Bitleitungen zugeordnet sind und bei dem im Falle von auftretenden Defekten eine Reparatur durch redundante Speicherzellen auf einfache Weise erfolgen kann.

Diese Aufgabe wird mit einem integrierten Speicher gemäß Patentanspruch 1 gelöst. Anspruch 6 betrifft ein vorteilhaftes Reparaturverfahren für einen Speicher. Vorteilhafte Aus- und Weiterbildungen der Erfindung sind Gegenstand abhängiger Ansprüche.

Der integrierte Speicher weist zwei normale Leseverstärker auf sowie zu wenigstens zwei einzeln adressierbaren normalen Spalten zusammengefaßte normale Bitleitungen, von denen aus jeder normalen Spalte jeweils wenigstens eine über je ein erstes Schaltelement mit je einem der normalen Leseverstärker verbunden ist. Die ersten Schaltelemente weisen Steuereingänge auf, wobei innerhalb einer jeden normalen Spalte jeweils die Steuereingänge aller ersten Schaltelemente miteinander verbunden sind, um ein gemeinsames Spaltenauswahlsignal zu empfangen. Der Speicher weist weiterhin Datenleitungen auf zur Übertragung von Daten von bzw. nach außerhalb des Speichers, von denen wenigstens jeweils eine mit jeweils einem der normalen Leseverstärker verbunden ist. Weiterhin weist er zwei erste redundante Leseverstärker auf und zu einer einzeln adressierbaren redundanten Spalte zusammengefaßte erste redundante Bitleitungen, von denen jeweils wenigstens eine über je ein zweites Schaltelement mit je einem der redundanten Leseverstärker verbunden ist. Die zweiten Schaltelemente weisen Steuereingänge auf, die miteinander verbunden sind, um ein gemeinsames redundantes Spaltenauswahlsignal zu empfangen. Die ersten redundanten Leseverstärker und die redundante Spalte sind zum Ersetzen der beiden normalen Leseverstärker und einer der normalen Spalten vorgesehen.

Während den normalen Leseverstärkern also mehrere normale Spalten zugeordnet sind, ist den ersten redundanten Leseverstärkern lediglich eine redundante Spalte mit redundanten Bitleitungen zugeordnet. Die Erfindung beruht auf der Erkenntnis, daß in der Praxis selten mehrere normale Spalten Defekte aufweisen. Würde man daher bei einem Defekt in einer der normalen Spalten alle normale Spalten durch entsprechend redundante Spalten ersetzen, wäre der Aufwand sehr viel größer als beim Gegenstand der Erfindung. Die Erfindung sieht lediglich eine redundante Spalte vor, die zur Reparatur von Defekten innerhalb einer normalen Spalte ausreicht. Im Redundanzfall werden zwar die normalen Leseverstärker mit der defekten Spalte durch die redundanten Leseverstärker mit der redundanten Spalte ersetzt, jedoch dienen die normalen Leseverstärker weiterhin dem Verstärken von aus den übrigen, nicht defekten normalen Spalten ausgelesenen Informationen.

Nach einer Weiterbildung weist der integrierte Speicher einen zweiten redundanten Leseverstärker auf, der über je ein drittes Schaltelement mit zweiten redundanten Bitleitungen verbunden ist, zum Ersetzen eines der normalen Leseverstärker und aller mit diesem über die ersten Schaltelemente verbundenen normalen Bitleitungen. Die dritten Schaltelemente weisen Steuereingänge auf, die zum Empfang je eines weiteren redundanten Spaltenauswahlsignals vorgesehen sind.

Der zweite redundante Leseverstärker ist für das Ersetzen eines der normalen Leseverstärker mit dessen sämtlichen normalen Bitleitungen vorgesehen. Er ermöglicht also insbesondere die Reparatur eines durch den Leseverstärker selbst bedingten Defektes. Da der integrierte Speicher nach der Weiterbildung sowohl die ersten redundanten Leseverstärker als auch den zweiten redundanten Leseverstärker aufweist, können diese in Abhängigkeit der Art des jeweils detektierten Defektes zur Reparatur des Speichers eingesetzt werden. Daher sieht das erfindungsgemäße Reparaturverfahren des integrierten Speichers vor, daß im Falle eines Defekts eines der normalen Leseverstärker dieser mit den mit ihm verbundenen normalen Bitleitungen durch den zweiten redundanten Leseverstärker und die mit diesem verbundenen zweiten redundanten Bitleitungen ersetzt wird und im Falle eines Defekts einer der normalen Bitleitungen einer der normalen Spalten letztere durch die redundante Spalte ersetzt wird.

Nach einer Weiterbildung ist der zweite redundante Leseverstärker über programmierbare Verbindungselemente, die in Abhängigkeit ihres Programmierzustandes entweder elektrisch leitfähig sind oder nicht, mit allen Datenleitungen verbunden, zur Übertragung von Daten zwischen einer der zweiten redundanten Bitleitungen und einer der Datenleitungen. Die Verbindungselemente ermöglichen, daß der zweite redundante Leseverstärker nur mit der Datenleitung bzw. den Datenleitungen verbunden ist, die vor einer durchgeführten Redundanzreparatur mit demjenigen normalen Leseverstärker verbunden sind, der durch den zweiten redundanten Leseverstärker ersetzt werden soll. Durch entsprechende Programmierung werden nur diejenigen Verbindungselemente leitfähig geschaltet, die den zweiten redundanten Leseverstärker mit diesen Datenleitungen verbinden. Die übrigen Verbindungselemente, die mit den anderen Datenleitungen verbunden sind, sind nach der Programmierung nicht leitfähig. Auf diese Weise wird vermieden, daß der zweite redundante Leseverstärker verstärkte Informationen, die aus den redundanten Speicherzellen ausgelesen werden, auf die verkehrten Datenleitungen ausgibt. Außerdem ist gewährleistet, daß der zweite redundante Leseverstärker einzuschreibende Daten nur von den richtigen Datenleitungen erhält.

Nach einer anderen Weiterbildung sind die normalen Leseverstärker über programmierbare Verbindungselemente, die in Abhängigkeit ihres Programmierzustands elektrisch leitfähig sind, mit den Datenleitungen verbunden. Diese Verbindungselemente ermöglichen es, einen der normalen Leseverstärker, der im Redundanzfall durch den zweiten redundanten Leseverstärker ersetzt worden ist, von seiner bzw. seinen Datenleitungen elektrisch zu trennen, indem die mit ihm verbundenen Verbindungselemente in den nicht-leitfähigen Zustand versetzt werden.

Eine Weiterbildung der Erfindung sieht vor, daß die normalen Bitleitungen, die mit demselben normalen Leseverstärker verbunden sind, verschachtelt mit den anderen normalen Bitleitungen angeordnet sind. Dies hat den großen Vorteil, daß anhand der geometrischen Verteilung von festgestellten Defekten ermittelt werden kann, ob es sich um einen Defekt eines der normalen Leseverstärker oder einen Defekt innerhalb einer der normalen Spalten (das heißt ein Defekt der normalen Bitleitungen bzw. normalen Speicherzellen) handelt. Häufig treten Defekte auf, die gleichzeitig mehrere benachbarte Bitleitungen betreffen. Dadurch, daß erfindungsgemäß diejenigen Bitleitungen nicht benachbart, sondern verschachtelt angeordnet sind, die jeweils demselben normalen Leseverstärker zugeordnet sind, ist es sehr unwahrscheinlich, daß bei Bitleitungsdefekten alle diese Bitleitungen gleichzeitig betroffen sind. Sie sind nämlich nicht benachbart zueinander angeordnet. Wird daher ein derartiger Defekt festgestellt, handelt es sich mit größter Wahrscheinlichkeit um einen Defekt des Leseverstärkers selbst. Entsprechend kann eine Reparatur dieses Leseverstärkers durch den zweiten redundanten Leseverstärker erfolgen. Handelt es sich dagegen um keinen Defekt eines der normalen Leseverstärker, sondern um einem Defekt einer der normalen Spalten, so sind mit hoher Wahrscheinlichkeit benachbarte Bitleitungen defekt, die mehreren der normalen Leseverstärker zugeordnet sind. Ein solcher Defekt kann daher einfach von einem Defekt eines der normalen Leseverstärker unterschieden und durch Einsatz der ersten redundanten Leseverstärker und der redundanten Spalte behoben werden.

Die Erfindung wird im folgenden anhand der Figuren näher erläutert, die Ausführungsbeispiele der Erfindung zeigen.
- Figur 1: zeigt ein Ausführungsbeispiel des erfindungsgemäßen integrierten Speichers und
- Figur 2: zeigt ein Ausführungsbeispiel des erfindungsgemäßen Reparaturverfahrens.

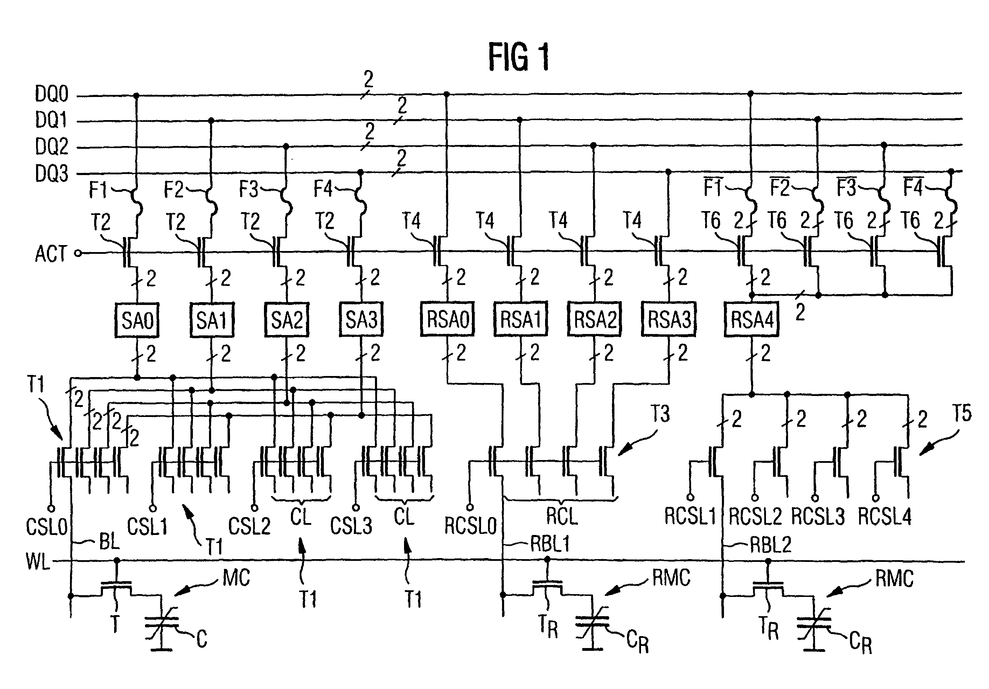

Figur 1 zeigt ein Ausführungsbeispiel des erfindungsgemäßen integrierten Speichers. Bei diesem handelt es sich um einen ferroelektrischen Speicher (FRAM bzw. FeRAM). Dieser weist in Kreuzungspunkten von normalen Bitleitungen BL und Wortleitungen WL Speicherzellen MC auf, die jeweils einen Auswahltransistor T und einen Speicherkondensator C mit einem ferroelektrischen Dielektrikum aufweisen. Der Speicherkondensator C ist über die steuerbare Strecke des Auswahltransistors T mit einer der normalen Bitleitungen BL verbunden. Das Gate des Auswahltransistors T ist mit einer der Wortleitungen WL verbunden. In Figur 1 ist nur eine der Speicherzellen MC dargestellt, obwohl in der Praxis eine Vielzahl von Speicherzellen pro Bitleitung BL und pro Wortleitung WL vorhanden sind. Der Speicher weist redundante Speicherzellen RMC auf, die in Kreuzungspunkten von redundanten Bitleitungen RBL1, RBL2 und den Wortleitungen WL angeordnet sind und die ebenso wie die normalen Speicherzellen MC aufgebaut sind.

Der Speicher in Figur 1 weist eine Vielzahl von normalen Leseverstärkern SAi auf, von denen nur vier dargestellt wurden. Bei den normalen Leseverstärkern SAi handelt es sich um differentielle Leseverstärker, die zum Übertragen differentieller Datensignale dienen. Jeweils vier Bitleitungspaare BL der normalen Bitleitungen sind zu normalen Spalten CL zusammengefaßt. Ein Bitleitungspaar BL aus jeder normalen Spalte CL ist mit je einem der normalen Leseverstärker SAi über erste n-Kanal-Transistoren T1 verbunden. Die Gates der ersten Transistoren T1 jeder normalen Spalte CL sind miteinander verbunden. Ihnen wird ein jeweils separates Spaltenauswahlsignal CSLi zugeführt. Im Betrieb werden über die Spaltenauswahlsignale CSLi nur jeweils die Bitleitungspaare BL einer der vier Spalten CL mit den vier normalen Leseverstärkern SAi verbunden. Die normalen Leseverstärker SAi sind über zweite Transistoren T2 vom n-Kanal-Typ sowie erste programmierbare Verbindungselemente Fi mit je einem Datenleitungspaar DQi verbunden. Bei einem Speicherzugriff werden alle zweiten Transistoren T2 über ihre Gates mittels eines Aktivierungssignals ACT leitend geschaltet, so daß Daten von den Datenleitungspaaren DQi über die normalen Leseverstärker SAi zu den Bitleitungspaaren BL einer der normalen Spalten CL übertragen werden können, deren Spaltenauswahlsignal CSLi einen hohen Pegel aufweist. Ebenso können von den Bitleitungspaaren dieser normalen Spalte CL Daten über die normalen Leseverstärker SAi zu den vier Datenleitungspaaren DQi übertragen werden.

Der Speicher weist weitere (nicht dargestellte) Gruppen von je vier normalen Leseverstärkern SAi mit den zugehörigen normalen Spalten CL auf, die jeweils mit den vier Datenleitungspaaren DQi verbunden sind. Während des Betriebes ist jedoch nur eine der normalen Spalten CL aktiviert, so daß in deren Speicherzellen MC Daten eingelesen oder aus ihnen ausgelesen werden können.

Der Speicher in Figur 1 weist weiterhin vier erste redundante Leseverstärker RSA0..3 auf, die über dritte Transistoren T3 vom n-Kanal-Typ mit je einem ersten redundanten Bitleitungspaar RBL1 verbunden sind. Die ersten redundanten Bitleitungspaare RBL1 bilden eine redundante Spalte RCL. Die ersten redundanten Leseverstärker RSA0..3 sind jeweils über vierte Transistoren T4 vom n-Kanal-Typ, deren Gates ebenfalls mit dem Aktivierungssignal ACT verbunden sind, mit jeweils einem der Datenleitungspaare DQi verbunden. Die Gates der dritten Transistoren T3 sind mit einem redundanten Spaltenauswahlsignal RCSL0 verbunden

Zusätzlich weist der integrierte Speicher in Figur 1 einen zweiten redundanten Leseverstärker RSA4 auf, der einerseits mit vier zweiten redundanten Bitleitungspaaren RBL2 über fünfte Transistoren T5 vom n-Kanal-Typ verbunden ist und andererseits über sechste Transistoren T6 von n-Kanal-Typ sowie zweite programmierbare Verbindungselemente /Fi mit allen Datenleitungspaaren DQi verbunden ist. Die Gates der beiden fünften Transistoren T5 jedes zweiten redundanten Bitleitungspaares RBL2 sind mit je einem weiteren redundanten Spaltenauswahlsignal RCSL1..4 verbunden. Die Gates der sechsten Transistoren T6 sind ebenfalls mit dem Aktivierungssignal ACT verbunden.

Beim hier betrachteten Speicher sind die normalen und redundanten Leseverstärker SAi, RSAi differentielle Leseverstärker, die einerseits mit Bitleitungspaaren BL, RBLi und andererseits mit Datenleitungspaaren DQi verbunden sind. Die Erfindung ist jedoch auch auf Speicher anwendbar, die Leseverstärker aufweisen, die nicht differentiell arbeiten, und die einerseits nur mit einer Bitleitung anstelle eines Bitleitungspaares und andererseits mit einer Datenleitung anstelle eines Datenleitungspaares zur Übertragung von Daten bei einem Schreibzugriff oder Lesezugriff verbunden sind.

Die redundante Spalte RCL in Figur 1 dient zum Ersetzen einer der normalen Spalten CL im Redundanzfall. Wird ein Defekt innerhalb einer der normalen Spalten CL festgestellt, wird das ihr zugeordnete Spaltenauswahlsignal CSLi bei Adressierung dieser Spalte unterdrückt und stattdessen das redundante Spaltenauswahlsignal RCSL0 aktiviert. Somit werden die mit den ersten redundanten Bitleitungspaaren RBL1 verbundenen redundanten Speicherzellen RMC anstelle der normalen Speicherzellen MC ausgewählt. Die normalen Leseverstärker SAi dienen jedoch weiterhin der Übertragung von oder zu den übrigen normalen Spalten CL, die keinen Defekt aufweisen.

Der zweite redundante Leseverstärker RSA4 dient der Reparatur eines der normalen Leseverstärker SAi. Er ersetzt diesen mitsamt dessen an ihn über die ersten Transistoren T1 angeschlossenen Bitleitungspaare BL. Hierzu ist es erforderlich, daß gleichzeitig zu jedem Spaltenauswahlsignal CSLi jeweils eines der weiteren redundanten Spaltenauswahlsignale RCSL1..4 aktiviert wird. Ist beispielsweise der normale Leseverstärker SA0 ganz links in Figur 1 defekt, werden zunächst die mit ihm verbundenen ersten Verbindungselemente F1 nicht-leitfähig geschaltet bzw. aufgetrennt, um ihn von seinem Datenleitungspaar DQ0 zu trennen. Außerdem werden die zweiten Verbindungselemente /F2, /F3 und /F4 aufgetrennt, so daß der zweite redundante Leseverstärker RSA4 nur noch mit dem Datenleitungspaar DQ0 verbunden ist, daß dem zu ersetzenden normalen Leseverstärker SA0 zugeordnet ist. Ein in Figur 1 nicht dargestellter redundanter Spaltendecoder wird so programmiert, daß er die weiteren redundanten Spaltenauswahlsignale RCSL1..4 in Abhängigkeit der normalen Spaltenauswahlsignal CSLi erzeugt. Bei diesem Ausführungsbeispiel ist zur Reparatur eines der vier normalen Leseverstärker SAi der redundante Spaltendecoder so programmiert, daß jedes der weiteren Spaltenauswahlsignale RCSL1..4 mit einem der Spaltenauswahlsignale CSLi übereinstimmt.

Bei den Verbindungselementen Fi, /Fi handelt es sich bei diesem Ausführungsbeispiel um Laserfuses, die nach der Herstellung des Speichers zunächst elektrisch leitfähig sind. Nach der Durchführung eines Speichertests können einzelne der Verbindungselemente mittels eines Laserstrahls aufgetrennt werden, so daß sie elektrisch nicht leitend werden. Die Verbindungselemente können jedoch auch auf andere Weise realisiert sein, beispielsweise durch Transistoren, deren Steuerpotential in Abhängigkeit der Redundanzprogrammierung in Registern gespeichert wird. Somit handelt es sich also um reversibel programmierbare Verbindungselemente.

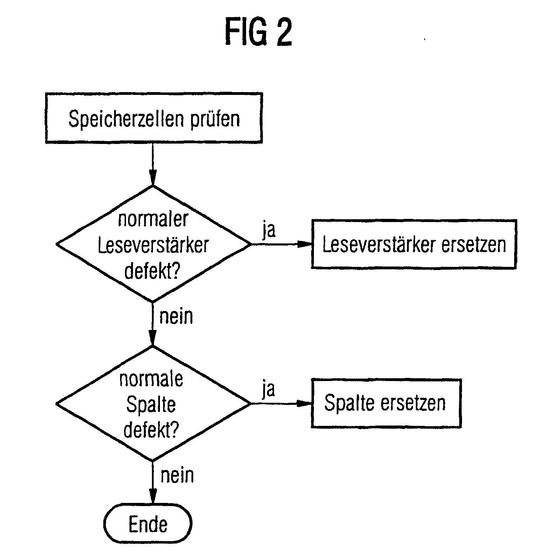

Figur 2 zeigt ein Ausführungsbeispiel des erfindungsgemäßen Reparaturverfahrens für den in Figur 1 dargestellten Speicher. Zunächst werden die normalen Speicherzellen MC geprüft. Dies geschieht durch Einschreiben von Daten über die Datenleitungspaare DQi, die normalen Leseverstärker SAi und die normalen Bitleitungspaare BL in die Speicherzellen MC und anschließendes Auslesen der Speicherzellen in umgekehrter Richtung. Wird dabei ein Defekt eines der normalen Leseverstärker SAi festgestellt, wird dieser durch den zweiten redundanten Leseverstärker RSA4 auf die oben beschriebene Weise ersetzt. Ist dagegen kein normaler Leseverstärker SAi defekt, wurde jedoch ein Defekt in einer der normalen Spalten CL festgestellt, wird die betreffende normale Spalte CL durch die redundante Spalte RCL ersetzt, wobei die ersten redundanten Leseverstärker RSA0..3 zum Einsatz kommen.

Der in Figur 1 dargestellte Speicher eignet sich daher vorteilhaft zur optimierten Reparatur verschiedener Fehlerarten, nämlich einerseits von Defekten innerhalb einer der normalen Spalten und andererseits von Defekten eines der normalen Leseverstärker SAi. In der Praxis sind die redundanten Leseverstärker RSAi jeweils einer großen Anzahl von normalen Leseverstärker SAi zugeordnet. Es sind daher wesentlich weniger redundante Leseverstärker RSAi und damit verbundene redundante Bitleitungspaare RBLi vorhanden, als normale Leseverstärker SAi und damit verbundene normale Bitleitungen BL.

Beim in Figur 1 dargestellten Speicher sind die Bitleitungspaare BL jeder normalen Spalte CL jeweils benachbart zueinander angeordnet. Daher sind die normalen Bitleitungspaare, jedes der normalen Leseverstärker jeweils verschachtelt mit den übrigen normalen Bitleitungspaaren angeordnet. Hierdurch ist es vorteilhaft möglich, nach der Durchführung eines Speichertests anhand der Testergebnisse und der dabei festgestellten Fehlermuster festzustellen, ob ein Defekt innerhalb einer der normalen Spalten CL oder ein Defekt eines der normalen Leseverstärker SAi vorliegt. In der Praxis kommt es nämlich häufig zu Fehlern aufgrund von Verunreinigungen, die beim Herstellungsprozeß des integrierten Speichers auftreten. Derartige Verunreinigungen, beispielsweise in Form von Staubpartikeln, führen dazu, daß häufig mehrere benachbart zueinander angeordnete Bitleitungen gleichzeitig defekt sind. Beim in Figur 1 dargestellten Speicher ist aufgrund der geometrischen Anordnung seiner normalen Bitleitungen BL leicht zu unterscheiden, ob der soeben beschriebene Fehler innerhalb einer der normalen Spalten CL oder ein Fehler eines der normalen Leseverstärker SAi vorliegt. Im letztgenannten Fall kommt es nämlich zu Fehlern bei allen mit diesem normalen Leseverstärker SAi verbundenen Bitleitungspaaren BL. Da diese aber erfindungsgemäß nicht nebeneinander, sondern verschachtelt mit den übrigen normalen Bitleitungspaaren angeordnet sind (da ja jeweils die Bitleitungspaare einer normalen Spalte CL benachbart zueinander angeordnet sind) kann ein solcher Fehler nicht durch eine typische Verunreinigung während des Herstellprozesses verursacht sein.

## Patentansprüche

1. Integrierter Speicher
- mit zwei normalen Leseverstärkern (SAi),
- mit zu wenigstens zwei einzeln adressierbaren normalen Spalten (CL) zusammengefaßten normalen Bitleitungen (BL), von denen aus jeder normalen Spalte jeweils wenigstens eine über je ein erstes Schaltelement (T1) mit je einem der normalen Leseverstärker (SAi) verbunden ist,
- dessen erste Schaltelemente (T1) Steuereingänge aufweisen, wobei innerhalb einer jeden normalen Spalte (CL) jeweils die Steuereingänge aller ersten Schaltelemente miteinander verbunden sind, um ein gemeinsames Spaltenauswahlsignal (CSLi) zu empfangen,
- mit Datenleitungen (DQi) zur Übertragung von Daten von bzw. nach außerhalb des Speichers, von denen wenigstens jeweils eine mit jeweils einem der normalen Leseverstärker (SAi) verbunden ist,
- mit zwei ersten redundanten Leseverstärkern (RSA0..3),
- mit zu einer einzeln adressierbaren redundanten Spalte (RCL) zusammengefaßten ersten redundanten Bitleitungen (RBL1), von denen jeweils wenigstens eine über je ein zweites Schaltelement (T3) mit je einem der redundanten Leseverstärker (RSA0..3) verbunden ist,
- dessen zweite Schaltelemente (T3) Steuereingänge aufweisen, die miteinander verbunden sind, um ein gemeinsames redundantes Spaltenauswahlsignal (RCSL0) zu empfangen,
- und dessen erste redundante Leseverstärker (RSA0..3) sowie dessen redundante Spalte (RCL) zum Ersetzen der beiden normalen Leseverstärker (SAi) und einer der normalen Spalten (CL) vorgesehen sind.

2. Integrierter Speicher nach Anspruch 1,
- mit einem zweiten redundanten Leseverstärker (RSA4), der über je ein drittes Schaltelement (T5) mit zweiten redundanten Bitleitungen (RBL2) verbunden ist, zum Ersetzen eines der normalen Leseverstärker (SAi) und aller mit diesem über die ersten Schaltelemente (T1) verbundenen normalen Bitleitungen (BL),
- dessen dritte Schaltelemente (T5) Steuereingänge aufweisen, die zum Empfang je eines weiteren redundanten Spaltenauswahlsignals (RCSL1..4) vorgesehen sind.

3. Integrierter Speicher nach Anspruch 2,
dessen zweiter redundanter Leseverstärker (RSA4) über programmierbare Verbindungselemente (/Fi), die in Abhängigkeit ihres Programmierzustands elektrisch leitfähig sind, mit allen Datenleitungen (DQi) verbunden ist, zur Übertragung von Daten zwischen einer der zweiten redundanten Bitleitungen (RBL2) und einer der Datenleitungen (DQi).

4. Integrierter Speicher nach Anspruch 2,
dessen normale Leseverstärker (SAi) über programmierbare Verbindungselemente (Fi), die in Abhängigkeit ihres Programmierzustands elektrisch leitfähig sind, mit den Datenleitungen (DQi) verbunden sind.

5. Integrierter Speicher nach einem der vorstehenden Ansprüche,
bei dem die normalen Bitleitungen (BL), die mit demselben normalen Leseverstärker (SAi) verbunden sind, verschachtelt mit den anderen normalen Bitleitungen angeordnet sind.

6. Verfahren zur Reparatur eines integrierten Speichers nach den Merkmalen der Ansprüche 1 und 2,
- bei dem im Falle eines Defekts eines der normalen Leseverstärker (SAi) dieser mit den mit ihm verbundenen normalen Bitleitungen (BL) durch den zweiten redundanten Leseverstärker (RSA4) und die mit diesem verbundenen zweiten redundanten Bitleitungen (RBL2) ersetzt wird,
- oder bei dem im Falle eines Defekts einer der normalen Bitleitungen (BL) einer der normalen Spalten (CL) diese durch die redundante Spalte (RCL) ersetzt wird.

## Claims

1. Integrated memory
- having two normal sense amplifiers (SAi),
- having normal bit lines (BL) which are combined to form at least two individually addressable normal columns (CL) and in each case at least one of which from each normal column is connected via a respective first switching element (T1) to a respective one of the normal sense amplifiers (SAi),
- whose first switching elements (T1) have control inputs, within each normal column (CL) the control inputs of all the first switching elements being in each case connected to one another in order to receive a common column select signal (CSLi),
- having data lines (DQi) for transferring data from or to outside the memory, at least in each case one of which is connected to a respective one of the normal sense amplifiers (SAi),
- having two first redundant sense amplifiers (RSA0..3),
- having first redundant bit lines (RBL1) which are combined to form an individually addressable redundant column (RCL) and in each case at least one of which is connected via a respective second switching element (T3) to a respective one of the redundant sense amplifiers (RSA0..3),
- whose second switching elements (T3) have control inputs which are connected to one another in order to receive a common redundant column select signal (RCSL0),
- and whose first redundant sense amplifiers (RSA0..3) and whose redundant column (RCL) are provided for replacing the two normal sense amplifiers (SAi) and one of the normal columns (CL).

2. Integrated memory according to Claim 1,
- having a second redundant sense amplifier (RSA4), which is connected via a respective third switching element (T5) to second redundant bit lines (RBL2), for replacing one of the normal sense amplifiers (SAi) and all the normal bit lines (BL) connected to the latter via the first switching elements (T1),
- whose third switching elements (T5) have control inputs which are provided for receiving a respective further redundant column select signal (RCSL1..4).

3. Integrated memory according to Claim 2,
whose second redundant sense amplifier (RSA4) is connected via programmable connection elements (/Fi), which are electrically conductive depending on their programming state, to all the data lines (DQi), for transferring data between one of the second redundant bit lines (RBL2) and one of the data lines (DQi).

4. Integrated memory according to Claim 2,
whose normal sense amplifiers (SAi) are connected via programmable connection elements (Fi), which are electrically conductive depending on their programming state, to the data lines (DQi).

5. Integrated memory according to one of the preceding claims,
in which the normal bit lines (BL) which are connected to the same normal sense amplifier (SAi) are arranged in an interleaved manner with the other normal bit lines.

6. Method for repairing an integrated memory according to the features of Claims 1 and 2,
- in which, in the case of a defect in one of the normal sense amplifiers (SAi), the latter with the normal bit lines (BL) connected to it is replaced by the second redundant sense amplifier (RSA4) and the second redundant bit lines (RBL2) connected thereto,
- or in which, in the case of a defect in one of the normal bit lines (BL) of one of the normal columns (CL), the latter is replaced by the redundant column (RCL).

## Revendications

1. Mémoire intégrée
- comprenant deux amplificateurs (SAi) normaux de lecture,
- comprenant des lignes (BL) de bits normales, rassemblées en au moins deux colonnes (CL) normales pouvant être adressées individuellement, lignes de bits dont, dans chaque colonne normale, respectivement l'une au moins est reliée par respectivement un premier élément (T1) de commutation à respectivement l'un des amplificateurs (SAi) normaux de lecture,
- dont les premiers éléments (T1) de commutation ont des entrées de commande, les entrées de commande de tous les premiers éléments de commutation étant reliées entre elles dans chaque colonne (CL) normale pour recevoir un signal (CSLi) commun de sélection de colonne,
- ayant des lignes (DQi) de données de transmission de données à la mémoire et hors de la mémoire, lignes de données dont l'une au moins respectivement est reliée à respectivement l'un des amplificateurs (SAi) normaux de lecture,
- ayant deux premiers amplificateurs (RSA0..3) redondants de lecture,
- ayant des premières lignes (RBL1) redondantes de bits, rassemblées en une colonne (RCL) redondante pouvant être adressée individuellement, lignes de bits dont respectivement l'une au moins est reliée par respectivement un deuxième élément (T3) de commutation à respectivement l'un des amplificateurs (RSA0..3) redondants,
- dont les deuxièmes éléments (T3) de commutation ont des entrées de commande, qui sont reliées entre elles pour recevoir un signal (RCSLO) commun redondant de sélection de colonne,
- et dont les premiers amplificateurs (RSA0..3) redondants de lecture, ainsi que leur colonne (RCL) redondante, sont prévus pour remplacer les deux amplificateurs (SAi) normaux de lecture et l'une des colonnes (CL) normales.

2. Mémoire intégrée selon la revendication 1,
- ayant un deuxième amplificateur (RSA4) redondant de lecture qui est relié par respectivement un troisième élément (T5) de commutation à des deuxièmes lignes (RBL2) redondantes de bits pour remplacer l'un des amplificateurs (SAi) normaux de lecture et toutes les lignes (BL) de bits normales reliées à celui-ci par les premiers éléments (T1) de commutation,
- dont des troisièmes éléments (T5) de commutation ont des entrées de commande, qui sont prévues pour recevoir respectivement un autre signal (RCSL1..4) redondant de sélection de colonne.

3. Mémoire intégrée selon la revendication 2,
dont les deuxièmes amplificateurs (RSA4) redondants de lecture sont reliés par des éléments (/Fi) de liaison programmables, qui sont aptes à conduire l'électricité en fonction de leur état de programmation, à toutes les lignes (DQi) de données pour transmettre des données entre l'une des deuxièmes lignes (RBL2) redondantes de bits et l'une des lignes (DQi) de données.

4. Mémoire intégrée selon la revendication 2,
dont des amplificateurs (SAi) normaux de lecture sont reliés par des éléments (Fi) de liaison programmables, qui sont aptes à conduire l'électricité en fonction de leur état de programmation, aux lignes (DQi) de données.

5. Mémoire intégrée selon l'une des revendications précédentes,
dans laquelle les lignes (BL) normales de bits qui sont reliées à de mêmes amplificateurs (SAi) normaux de lecture sont disposées à emboîtement avec les autres lignes normales de bits.

6. Procédé de réparation d'une mémoire intégrée suivant les caractéristiques des revendications 1 et 2,
- dans lequel, dans le cas d'un défaut de l'un des amplificateurs (SAi) normaux de lecture, on remplace celui-ci avec les lignes (BL) normales de bits qui lui sont reliées par le deuxième amplificateur (RSA4) redondant de lecture et par les deuxièmes lignes (RBL2) redondantes de bits qui sont reliées à celui-ci,
- ou dans le cas d'un défaut de l'une des lignes (BL) normales de bits de l'une des colonnes (CL) normales, on remplace celle-ci par la colonne (RCL) redondante.
